# FASCICULE DE BREVET EUROPEEN

(11) **EP 1 016 871 B1**
(45) Date de publication et mention de la délivrance du brevet: **07.02.2007**
(21) Numéro de dépôt: 99403277.9
(22) Date de dépôt: 24.12.1999
(51) Int. Cl.: G01R 33/44

(54) **Mesure en quantité contrôlée d'un produit par RMN**
Messung eines Produkts in kontrollierter Quantität mittels NMR
Measurement of a product in controlled quantity by means of NMR

(30) Priorité: 29.12.1998 FR 9816540
(43) Date de publication de la demande: 05.07.2000
(73) Titulaire: COMMISSARIAT A L'ENERGIE ATOMIQUE, 75015 Paris (FR)
(72) Inventeur: Locatelli, Marcel, 38330 Montbonnot (FR); Sonrel, Claude, 38320 Brie et Angonnes (FR)
(74) Mandataire: Weber, Etienne Nicolas

(56) Documents cités:
- US-A- 4 701 705
- US-A- 4 866 385
- S.L.DUCE ET AL.: "Nuclear Magnetic Resonance Imaging of Dairy Products in Two and Three Dimensions" INTERNATIONAL DAIRY JOURNAL, vol. 5, 1995, pages 311-319, XP002114093
- M.ROSENBERG ET AL.: "Magnetic Resonance Imaging of Cheese Structure" FOOD STRUCTURE, vol. 10, 1991, pages 185-192, XP002114094

## Description

### Domaine technique

La présente invention concerne la mesure en quantité contrôlée d'un produit constitué d'une matière à densité homogène de protons détectables par une mesure RMN, ce produit pouvant comporter des zones sans matière et de répartition inconnue. Elle permet la mesure d'une quantité de ce produit et sa partition sans avoir à le peser.

L'invention s'applique en particulier à la découpe à poids contrôlé de produits alimentaires comportant de nombreux trous tels que le pain de mie, l'emmenthal, la pâte de pâtisserie ou le jambon.

### Etat de la technique

Les distributeurs désirent proposer des quantités de produit définies. Pour des raisons d'étiquetage et de vente promotionnelle, ils souhaitent conditionner certains de leurs produits en parts de poids constant. Le contrôle de la quantité à la découpe avant la mise sous emballage pose un problème délicat et qui n'a pas encore été résolu de façon satisfaisante. En effet, le volume des trous présents dans le produit est une variable aléatoire et il est difficile d'évaluer le poids d'une part à la découpe.

Par ailleurs, la technique de mesure par résonance magnétique nucléaire (RMN) pour détecter la présence de protons d'hydrogène est bien connue. Des techniques d'imagerie par RMN ont été proposées pour l'analyse de matière poreuse. Le principe consiste à visualiser les trous présents dans la matière, à les comptabiliser et à les soustraire du volume total. Ces techniques sont longues, onéreuses et peu précises. La précision nécessaire de détection en volume est de l'ordre du mm³. De plus, si le produit à examiner présente de petits trous (inférieurs au mm³), ceux-ci ne sont pas détectés. La précision peut être améliorée à condition de passer en haute résolution, mais alors la mise en oeuvre est encore plus onéreuse.

### Exposé de l'invention

La présente invention a été conçue pour remédier à ces inconvénients. Elle est basée sur le principe de la mesure de la quantité de matière présente dans le produit à examiner et ne se préoccupe pas des trous présents dans le produit. En effet, l'air présent dans les trous (dans le cas de produits alimentaires) ne peut pas être détecté par RMN car il n'y a pas assez de protons présentant un moment magnétique. On sait en effet que les seuls protons détectables par RMN sont les protons d'hydrogène, du carbone, du sodium et du phosphore, voire des gaz polarisés comme l'hélium 3 ou le xénon.

L'invention a donc pour objet un procédé de mesure en quantité contrôlée d'un produit constitué d'une matière à densité homogène de protons détectables par une mesure RMN et pouvant comporter des zones sans matière, la densité en protons de ladite matière étant connue, comprenant les étapes suivantes :
- déplacement du produit, à une vitesse déterminée et dans une direction déterminée, de façon à en soumettre des tranches successives à un signal d'excitation de mesure RMN,
- récupération des signaux RMN fournis en réponse par chaque tranche soumise audit signal d'excitation,
- traitement des signaux RMN récupérés pour en déduire, à partir de la densité en protons connue de ladite matière, la quantité de matière soumise à la mesure RMN jusqu'à l'obtention du poids de produit désiré.

Le signal d'excitation de mesure RMN peut comprendre un champ magnétique de polarisation comportant un profil d'induction tel qu'il permet, pour chaque tranche soumise audit signal d'excitation, de récupérer des signaux RMN correspondant aux protons détectables et résonnants dans une gamme de fréquence déterminée. B étant le champ magnétique de polarisation, ΔB la largeur du profil d'induction et Δf la gamme de fréquence déterminée, on a les relations suivantes : f = γ.B et Δf = γ.ΔB, γ étant le facteur gyromagnétique du proton. Le profil d'induction peut être choisi parmi le profil à gradient d'induction constant, le profil présentant un maximum, le profil en plateau, le profil en sommet et le profil à double gradient.

Selon une première variante, ladite mesure RMN étant effectuée sur des tranches adjacentes du produit, l'étape de traitement des signaux RMN comprend la mesure de la quantité de protons de chaque tranche adjacente, le calcul du poids de chaque tranche adjacente et le cumul de ces poids jusqu'à l'obtention du poids de produit désiré.

Selon une deuxième variante, ladite mesure RMN étant effectuée sur des tranches non adjacentes, l'étape de traitement des signaux RMN comprend la mesure de la quantité de protons de chaque tranche examinée, l'obtention du profil de variation de la quantité de protons par tranche et le calcul, par intégration, du profil du poids de produit qui a défilé jusqu'à l'obtention du poids de produit désiré.

Le procédé peut comprendre en outre une étape de prélèvement de la part de produit correspondant au poids désiré.

L'invention a aussi pour objet un dispositif de mesure en poids contrôlé d'un produit constitué d'une matière à densité homogène de protons détectables par une mesure RMN et pouvant comporter des zones sans matière, le dispositif comportant :
- des moyens de mesure RMN aptes à détecter lesdits protons,
- des moyens de déplacement du produit, à une vitesse déterminée et dans une direction déterminée, pour soumettre des tranches successives de ce produit à un signal d'excitation produit par lesdits moyens de mesure RMN,
- des moyens de traitement des signaux RMN fournis en réponse par chaque tranche soumise audit signal d'excitation, permettant de déduire, par comparaison avec la densité en protons connue de ladite matière, la quantité de matière soumise à la mesure RMN jusqu'à l'obtention du poids de produit désiré.

Avantageusement, les moyens de mesure RMN comprennent une structure à aimants permanents, choisie parmi les types "Watson", "H" ou "C", destinée à fournir un champ magnétique de polarisation. Ils peuvent aussi comprendre une structure du type à électro-aimant pour fournir le champ magnétique de polarisation.

Les moyens de mesure RMN peuvent comprendre des moyens permettant de faire varier le champ magnétique de polarisation des moyens de mesure selon un profil d'induction tel qu'il permet, pour chaque tranche soumise audit signal d'excitation, de récupérer des signaux RMN correspondant à des protons détectables et résonnants dans une bande de fréquence déterminée.

Selon une première variante, les moyens de traitement des signaux RMN comportent des moyens permettant de mesurer la quantité de protons de tranches successives adjacentes, de calculer le poids de chaque tranche adjacente et de cumuler ces poids jusqu'à l'obtention du poids de produit désiré.

Selon une deuxième variante, les moyens de traitement des signaux RMN comportent des moyens permettant de mesurer la quantité de protons de tranches non adjacentes, de tracer le profil de variation de la quantité de protons par tranche et de calculer par intégration du profil le poids du produit qui a défilé, jusqu'à l'obtention du poids de produit désiré.

Le dispositif peut comprendre en outre des moyens de prélèvement de la part de produit correspondant au poids désiré.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est un diagramme représentant la décroissance du signal RMN émis par des protons suite à une impulsion dite 90°,
- la figure 2 est un diagramme représentant la décroissance du signal RMN émis par des protons dans une séquence CPMG,
- la figure 3 est une vue schématique d'un dispositif de mesure en poids contrôlé selon la présente invention,
- la figure 4 est un diagramme représentant un profil d'induction pour un champ magnétique de polarisation,
- la figure 5 est un diagramme illustratif d'une application particulière de l'invention.

### Description détaillée de modes de réalisation de l'invention

L'amplitude du signal RMN émis par des protons qui ont été au préalable excités à partir d'un signal électromagnétique à la fréquence de résonance (fréquence définie par la valeur de l'induction magnétique de polarisation) est directement proportionnelle au moment magnétique des protons et donc à la quantité de ces protons. Une fois l'excitation supprimée, le système de protons retourne à son état initial avec des temps de relaxation dépendant de l'environnement. La mesure consiste à détecter l'évolution du signal dans le temps puis, par extrapolation, en déduire la valeur à l'origine des temps. Cette valeur est proportionnelle à la quantité de protons excités. Plusieurs techniques peuvent être utilisées pour parvenir à ce résultat.

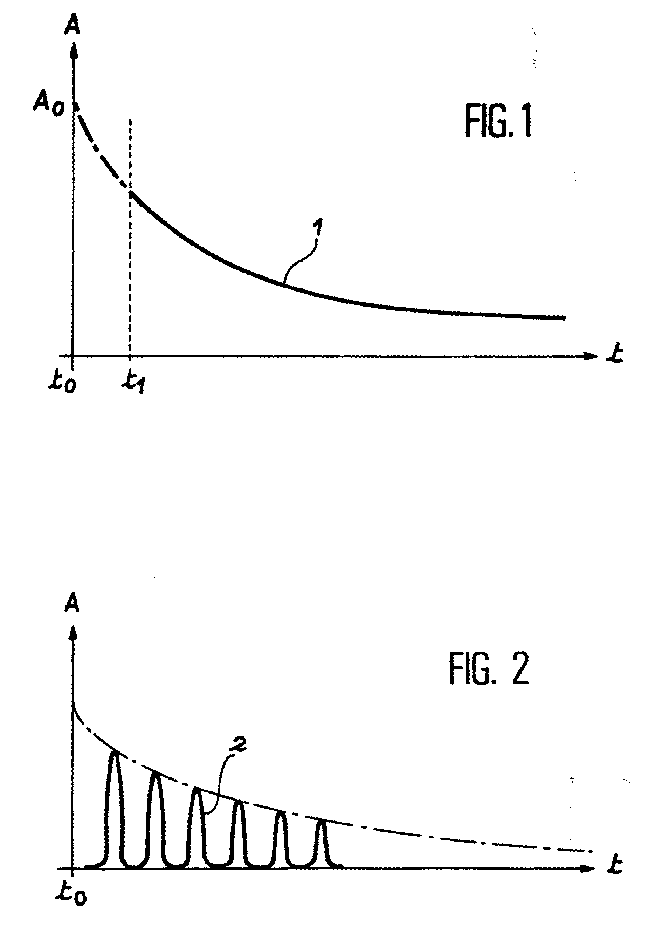

Une première technique est illustrée par le graphique représenté à la figure 1. Ce graphique représente l'amplitude A du signal RMN émis par des protons excités en fonction du temps. La courbe 1 représente la décroissance du signal suite à une impulsion dite 90°. Ce signal est détecté à partir du temps t₁. A partir de l'allure de cette décroissance, on peut en extrapoler la valeur A₀ à l'origine des temps t₀ et donc connaître la quantité de protons excités.

Une deuxième technique est illustrée par le graphique représenté à la figure 2. Ce graphique représente la décroissance du signal RMN émis par des protons excités dans une séquence de mesure CPMG (Carr-Purcell-Meiboom-Gill). Ces séquences permettent d'obtenir la décroissance de l'amplitude A des impulsions de détection 2 en fonction du temps t. De l'extrapolation de l'amplitude des impulsions à l'origine des temps t₀, on obtient une valeur proportionnelle à la quantité de protons excités. Ce type de séquence permet d'éliminer des effets parasites dus par exemple à des inhomogénéités locales de l'induction de polarisation.

Pour un système statique, la mesure du signal dans une induction homogène fournit directement la quantité de protons.

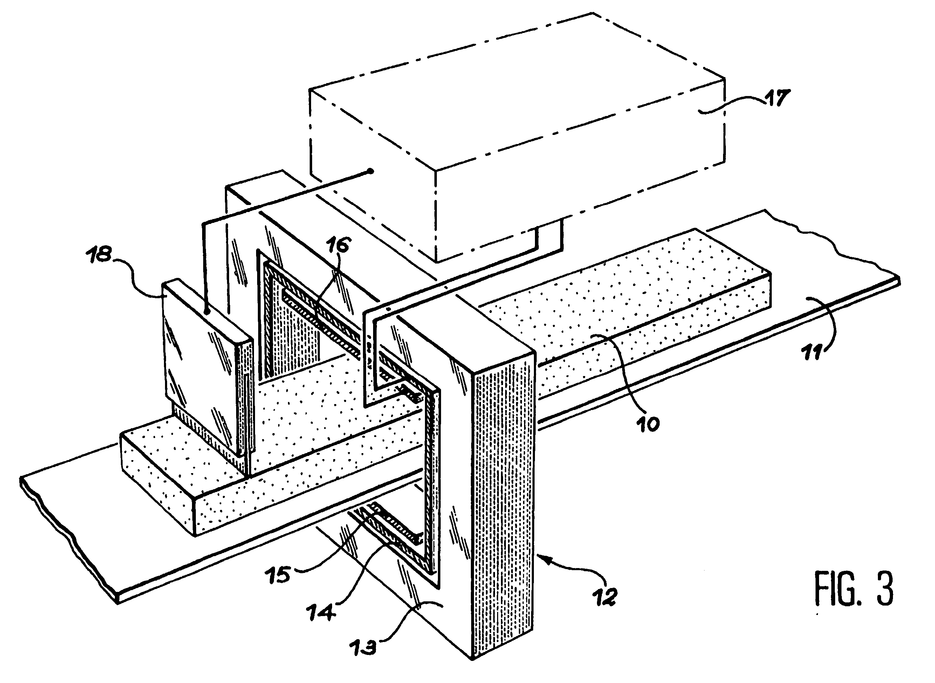

La figure 3 représente un dispositif de mesure en poids contrôlé selon la présente invention. Le produit 10, dont on veut prélever une part de poids déterminé, est disposé sur un tapis mobile 11 destiné à le déplacer à une vitesse déterminée dans l'axe d'un organe 12 de mesure RMN. L'organe 12, dans l'exemple représenté, comprend une structure "Watson" 13 à aimants permanents permettant la production d'un champ magnétique de polarisation. Il comprend encore une bobine d'induction 14 pour créer un gradient de champ magnétique s'ajoutant au champ magnétique de polarisation. Il comprend aussi des antennes 15 et 16 servant à émettre un champ magnétique RF vers le produit 10 et à détecter le signal émis en réponse par les protons détectables. Un organe d'instrumentation 17 permet de gérer l'ensemble des paramètres expérimentaux : séquence RMN, analyse des résultats, contrôle du déplacement du tapis, commande par exemple de la découpe effectuée au moyen de l'organe de découpe 18.

En déplaçant le produit 10 et en accumulant les signaux recueillis, on détermine la quantité de protons qui a défilé. Pour un produit dont on connaît la densité de protons par unité de volume de matière ou de poids, la connaissance de la quantité de protons permet de remonter à la quantité de produit ou au poids. Dans le cas de produits alimentaires, les protons considérés sont ceux de l'hydrogène de l'eau et des lipides. Du point de vue résonance magnétique, ces protons résonnent à des fréquences légèrement différentes, la différence entre ces fréquences représentant quelques parties par million. La mesure en champ magnétique de polarisation statique dans une induction homogène peut permettre de séparer les deux types de protons. Dans le cas de la mesure avec un gradient de champ de polarisation, les deux types de protons sont détectés simultanément.

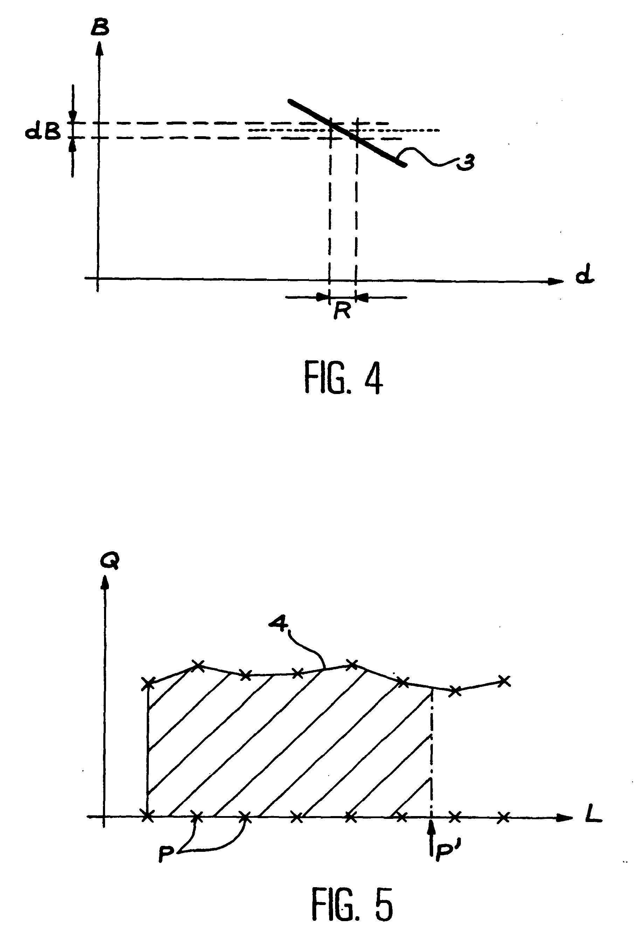

La figure 4 montre un profil d'induction avec gradient du champ magnétique de polarisation (courbe 3) pouvant être mis en oeuvre par la présente invention. L'induction de polarisation B est représentée en fonction du déplacement d du produit. Le produit défile dans la zone sensible du dispositif RMN correspondant par exemple à une tranche d'épaisseur inférieure à la précision de la découpe souhaitée. L'électronique de détection est à bande étroite avec df=γdB, où γ est le coefficient gyromagnétique spécifique au type de proton et dB la variation de l'induction dans la zone de mesure. Cette bande correspond à celle de la fréquence des protons situés dans la tranche examinée. Le signal détecté est donc proportionnel à la quantité de protons dans la zone sensible.

Le profil d'induction doit être tel que la résolution transversale soit meilleure que la précision demandée. Pour un système à gradient, en RMN, la résolution spatiale R (voir la figure 4) dépend de la largeur de bande df de l'électronique et du gradient du champ magnétique G selon la formule R=df/G/γ. Pour le proton d'hydrogène γ vaut 2,68.10⁸ rd/s/T. A titre d'exemple, si R=0,2 mm et df=1 kHz, alors dG vaut 12 gauss/m soit 0,0012 tesla/m.

La solution décrite précédemment, qui consiste à cumuler les poids de chacune des tranches mesurées, peut être simplifiée si le produit à découper présente des trous de taille importante, comme pour la mie de pain où les trous sont de l'ordre de quelques millimètres. Dans ce cas, à l'échelle du mm par exemple, la densité du matériau varie peu et une mesure tous les mm est suffisante. La tranche de mesure n'a plus besoin d'être de dimension égale à la résolution et le gradient peut s'étaler sur 1 mm au lieu de 0,2 mm. De même, la forme de la zone impliquée par la mesure n'est plus aussi importante. Il y a donc moins de contraintes sur la qualité du gradient et la mesure en est simplifiée.

La figure 5 illustre cette deuxième variante du procédé selon l'invention. Elle montre un diagramme représentant la quantité Q de produit mesuré en fonction de la longueur L du produit en cours de défilement. Les points P représentent les points de mesure, par exemple tous les millimètres de la longueur du produit en cours de défilement. A partir des quantités mesurées pour les points P, on peut obtenir par extrapolation un profil 4 permettant le calcul du poids de produit mesuré par intégration de ce profil. On peut alors définir le point de découpe P' correspondant au poids de produit désiré.

## Revendications

1. Procédé de mesure en quantité contrôlée d'un produit (10) constitué d'une matière à densité homogène de protons détectables par une mesure RMN et pouvant comporter des zones sans matière, la densité en protons de ladite matière étant connue, comprenant les étapes suivantes :
- déplacement du produit (10), à une vitesse déterminée et dans une direction déterminée, de façon à en soumettre des tranches successives à un signal d'excitation de mesure RMN,
- récupération des signaux RMN fournis en réponse par chaque tranche soumise audit signal d'excitation,
- traitement des signaux RMN récupérés pour en déduire, à partir de la densité en protons connue de ladite matière, la quantité de matière soumise à la mesure RMN jusqu'à l'obtention du poids de produit désiré.

2. Procédé selon la revendication 1, **caractérisé en ce que** le signal d'excitation de mesure RMN comprend un champ magnétique de polarisation comportant un profil d'induction (3) tel qu'il permet, pour chaque tranche soumise audit signal d'excitation, de récupérer des signaux RMN correspondant aux protons détectables et résonnants dans une gamme de fréquence déterminée.

3. Procédé selon la revendication 2, **caractérisé en ce que** ledit profil d'induction (3) est choisi parmi le profil à gradient d'induction constant, le profil présentant un maximum, le profil en plateau, le profil en sommet et le profil à double gradient.

4. Procédé selon l'une quelconque des revendications 1 à 3, **caractérisé en ce que** ladite mesure RMN étant effectuée sur des tranches adjacentes du produit, l'étape de traitement des signaux RMN comprend la mesure de la quantité de protons de chaque tranche adjacente, le calcul du poids de chaque tranche adjacente et le cumul de ces poids jusqu'à l'obtention du poids de produit désiré.

5. Procédé selon l'une quelconque des revendications 1 à 3, **caractérisé en ce que** ladite mesure RMN étant effectuée sur des tranches non adjacentes, l'étape de traitement des signaux RMN comprend la mesure de la quantité de protons de chaque tranche examinée, l'obtention du profil de variation de la quantité de protons par tranche et le calcul, par intégration, du profil du poids de produit qui a défilé jusqu'à l'obtention du poids de produit désiré.

6. Procédé selon l'une quelconque des revendications 1 à 5, **caractérisé en ce qu'**il comprend en outre une étape de prélèvement de la part de produit correspondant au poids désiré.

7. Dispositif de mesure en poids contrôlé d'un produit (10) constitué d'une matière à densité homogène de protons détectables par une mesure RMN et pouvant comporter des zones sans matière, le dispositif comportant :
- des moyens de mesure RMN (12) aptes à détecter lesdits protons,
- des moyens de déplacement (11) du produit (10), à une vitesse déterminée et dans une direction déterminée, pour soumettre des tranches successives de ce produit à un signal d'excitation produit par lesdits moyens de mesure RMN (12),
- des moyens de traitement (17) des signaux RMN fournis en réponse par chaque tranche soumise audit signal d'excitation, adaptés à déduire, par comparaison avec la densité en protons connue de ladite matière, la quantité de matière soumise à la mesure RMN jusqu'à l'obtention du poids de produit désiré.

8. Dispositif selon la revendication 7, **caractérisé en ce que** lesdits moyens de mesure RMN (12) comprennent une structure à aimants permanents (13), choisie parmi les types "Watson", "H" ou "C", destinée à fournir un champ magnétique de polarisation.

9. Dispositif selon la revendication 7, **caractérisé en ce que** lesdits moyens de mesure RMN comprennent une structure du type à électro-aimant, destinée à fournir un champ magnétique de polarisation.

10. Dispositif selon l'une quelconque des revendications 7 à 9, **caractérisé en ce que** lesdits moyens de mesure RMN comprennent des moyens (14) permettant de faire varier le champ magnétique de polarisation des moyens de mesure selon un profil d'induction tel qu'il permet, pour chaque tranche soumise audit signal d'excitation, de récupérer des signaux RMN correspondant à des protons détectables et résonnants dans une bande de fréquence déterminée.

11. Dispositif selon l'une quelconque des revendications 7 à 10, **caractérisé en ce que** lesdits moyens de traitement des signaux RMN (17) comportent des moyens permettant de mesurer la quantité de protons de tranches successives adjacentes, de calculer le poids de chaque tranche adjacente et de cumuler ces poids jusqu'à l'obtention du poids de produit désiré.

12. Dispositif selon l'une quelconque des revendications 7 à 10, **caractérisé en ce que** lesdits moyens de traitement des signaux RMN (17) comportent des moyens permettant de mesurer la quantité de protons de tranches non adjacentes, de tracer le profil de variation de la quantité de protons par tranche et de calculer par intégration du profil le poids du produit qui a défilé, jusqu'à l'obtention du poids de produit désiré.

13. Dispositif selon l'une quelconque des revendications 7 à 12, **caractérisé en ce qu'**il comprend en outre des moyens de prélèvement (18) de la part de produit correspondant au poids désiré.

## Claims

1. Method for measuring a controlled quantity of a product (10) consisting of a material with a homogeneous density of protons detectable by an NMR measurement, which may also include zones without material, the proton density of the said material being known, comprising the following steps:
- moving the product (10) at a determined speed and in a determined direction, so as to subject successive slices of it to an NMR measurement excitation signal,
- recovering the NMR signals provided in response by each slice subjected to the said excitation signal,
- processing the recovered NMR signals in order to deduce from them, on the basis of the known proton density of the said material, the quantity of material subjected to the NMR measurement until the desired weight of product is obtained.

2. Method according to Claim 1, **characterized in that** the NMR measurement excitation signal comprises a polarization magnetic field having an induction profile (3) such that, for each slice subjected to the said excitation signal, it makes it possible to recover NMR signals corresponding to the detectable protons resonant in a determined frequency range.

3. Method according to Claim 2, **characterized in that** the said induction profile (3) is selected from the constant induction gradient profile, the profile with a maximum, the plateau profile, the peak profile and the double gradient profile.

4. Method according to any one of Claims 1 to 3, **characterized in that**, the said NMR measurement being carried out on adjacent slices of the product, the step of processing the NMR signals comprises measuring the quantity of protons of each adjacent slice, calculating the weight of each adjacent slice and summing these weights until the desired weight of product is obtained.

5. Method according to any one of Claims 1 to 3, **characterized in that**, the said NMR measurement being carried out on non-adjacent slices, the step of processing the NMR signals comprises measuring the quantity of protons of each slice examined, obtaining the variation profile of the quantity of protons per slice and calculating, by integration, the profile of the weight of product which has passed through until the desired weight of product is obtained.

6. Method according to any one of Claims 1 to 5, **characterized in that** it furthermore comprises a step of removing the part of product corresponding to the desired weight.

7. Device for measuring a controlled quantity of a product (10) consisting of a material with a homogeneous density of protons detectable by an NMR measurement, which may also include zones without material, the device comprising:
- NMR measurement means (12) capable of detecting the said protons,
- means (11) for moving the product (10) at a determined speed and in a determined direction, in order to subject successive slices of this product to an excitation signal produced by the said NMR measurement means (12),
- means (17) for processing the NMR signals provided in response by each slice subjected to the said excitation signal, suitable for deducing from them, by comparison with the known proton density of the said material, the quantity of material subjected to the NMR measurement until the desired weight of product is obtained.

8. Device according to Claim 7, **characterized in that** the said NMR measurement means (12) comprise a permanent magnet structure (13) selected from the "Watson", "H" or "C" types, which is intended to provide a polarization magnetic field.

9. Device according to Claim 7, **characterized in that** the said NMR measurement means comprise a structure of the electromagnet type, which is intended to provide a polarization magnetic field.

10. Device according to any one of Claims 7 to 9, **characterized in that** the said NMR measurement means comprise means (14) for varying the polarization magnetic field of the measurement means according to an induction profile such that it makes it possible, for each slice subjected to the said excitation signal, to recover NMR signals corresponding to detectable protons resonant in a determined frequency band.

11. Device according to any one of Claims 7 to 10, **characterized in that** the said NMR signal processing means (17) have means for measuring the quantity of protons of successive adjacent slices, calculating the weight of each adjacent slice and summing these weights until the desired weight of product is obtained.

12. Device according to any one of Claims 7 to 10, **characterized in that** the said NMR signal processing means (17) have means for measuring the quantity of protons of non-adjacent slices, tracing the variation profile of the quantity of protons per slice and for calculating, by integrating the profile, the weight of the product which has passed through, until the desired weight of product is obtained

13. Device according to any one of Claims 7 to 12, **characterized in that** it furthermore comprises means (18) for removing the product part corresponding to the desired weight.

## Patentansprüche

1. Verfahren zur kontrollierten Quantitätsmessung eines Produkts (10), gebildet durch einen Stoff mit einer homogenen Dichte von mittels einer NMR-Messung detektierbaren Protonen, der auch Zonen ohne Stoff enthalten kann, wobei die Protonendichte des genannten Stoffs bekannt ist, folgende Schritte umfassend:
- Verschiebung des Produkts (10) mit einer bestimmten Geschwindigkeit und in einer festgelegten Richtung, um aufeinanderfolgende Scheiben einem NMR-Messungserregungssignal zu unterziehen,
- Rückgewinnung der durch jede dem genannten Erregungssignal unterzogenen Scheibe gelieferten NMR-Antwortsignale,
- Verarbeitung der rückgewonnenen NMR-Signale, um davon aufgrund der bekannten Protonendichte des genannten Stoffs die der NMR-Messung unterzogene Stoffquantität abzuleiten, bis zum Erreichen des gewünschten Produktgewichts.

2. Verfahren nach Anspruch 1, **dadurch gekennzeichnet, dass** das NMR-Messungserregungssignal ein magnetisches Polarisationsfeld mit einem solchen Induktionsprofil (3) umfasst, dass es möglich ist, für jede dem genannten Erregungssignal unterzogene Scheibe NMR-Signale rückzugewinnen, die den detektierbaren und in einem bestimmten Frequenzbereich schwingenden Protonen entsprechen.

3. Verfahren nach Anspruch 2, **dadurch gekennzeichnet, dass** das genannte Induktionsprofil (3) ausgewählt wird unter dem Profil mit konstantem Induktionsgradienten, dem ein Maximum aufweisenden Profil, dem Plateau-Profil, dem Gipfel-Profil und dem Doppelgradienten-Profil.

4. Verfahren nach einem der Ansprüche 1 bis 3, **dadurch gekennzeichnet, dass** die NMR-Messung bei benachbarten Scheiben des Produkts durchgeführt wird, wobei der Schritt zur Verarbeitung der NMR-Signale das Messen des Protonenquantums jeder benachbarten Scheibe, die Berechnung des Gewichts jeder benachbarten Scheibe und die Kumulierung dieser Gewichte bis zum Erreichen des gewünschten Produktgewichts umfasst.

5. Verfahren nach einem der Ansprüche 1 bis 3, **dadurch gekennzeichnet, dass** die NMR-Messung bei nicht-benachbarten Scheiben des Produkts durchgeführt wird, wobei der Schritt zur Verarbeitung der NMR-Signale das Messen des Protonenquantums jeder examinierten Scheibe, die Erstellung des Veränderungsprofils des Protonenquantums pro Scheibe und die Berechnung - durch Integration - des Profils des Produktgewichts umfasst, das die Messvorrichtung bis zum Erreichen des gewünschten Produktgewichts passiert hat.

6. Verfahren nach einem der Ansprüche 1 bis 5, **dadurch gekennzeichnet, dass** es außerdem einen Schritt zur Entnahme des Teils des Produkts umfasst, der dem gewünschten Gewicht entspricht.

7. Vorrichtung zur kontrollierten Gewichtsmessung eines Produkts (10), gebildet durch einen Stoff mit homogener Dichte von mittels einer NMR-Messung detektierbaren Protonen, der auch Zonen ohne Stoff enthalten kann,
wobei diese Vorrichtung umfasst:
- NMR-Messeinrichtungen (12), fähig die genannten Protonen zu detektieren,
- Einrichtungen (11) zur Verschiebung des Produkts (10) mit einer bestimmten Geschwindigkeit und in einer festgelegten Richtung, um aufeinanderfolgende Scheiben dieses Produkts einem durch die genannten NMR-Messeinrichtungen (12) erzeugten Erregungssignal zu unterziehen,
- Einrichtungen (17) zur Verarbeitung der durch jede dem genannten Erregungssignal unterzogenen Scheibe gelieferten NMR-Antwortsignale, die ermöglichen, durch Vergleich mit der bekannten Protonendichte des genannten Stoffs die der NMR-Messung unterzogene Stoffmenge bis zum Erreichen des gewünschten Produktgewichts abzuleiten.

8. Vorrichtung nach Anspruch 7, **dadurch gekennzeichnet, dass** die genannten NMR-Messeinrichtungen (12) eine Permanentmagnete-Struktur (13) umfassen, ausgewählt unter den Typen "Watson", "H" oder "C" und dazu bestimmt, ein magnetisches Polarisationsfeld zu erzeugen.

9. Vorrichtung nach Anspruch 7, **dadurch gekennzeichnet, dass** die genannten NMR-Messeinrichtungen (12) eine Struktur des Typs Elektromagnet umfassen, dazu bestimmt, ein magnetisches Polarisationsfeld zu erzeugen.

10. Vorrichtung nach einem der Ansprüche 7 bis 9, **dadurch gekennzeichnet, dass** die genannten NMR-Messeinrichtungen Einrichtungen (14) umfassen, die ermöglichen, das magnetische Polarisationsfeld der Messeinrichtungen entsprechend einem solchen Induktionsprofil zu variieren, dass es möglich ist, für jede der dem genannten Erregungssignal unterzogenen Scheiben NMR-Signale rückzugewinnen, die den detektierbaren und in einem bestimmten Frequenzband schwingenden Protonen entsprechen.

11. Vorrichtung nach einem der Ansprüche 7 bis 10, **dadurch gekennzeichnet, dass** die genannten Signalverarbeitungseinrichtungen (17) Einrichtungen umfassen, die ermöglichen, das Protonenquantum aufeinanderfolgender benachbarter Scheiben zu messen, das Gewicht jeder benachbarten Scheibe zu berechnen und diese Gewichte bis zum Erreichen des gewünschten Produktgewichts zu kumulieren.

12. Vorrichtung nach einem der Ansprüche 7 bis 10, **dadurch gekennzeichnet, dass** die genannten Signalverarbeitungseinrichtungen (17) Einrichtungen umfassen, die ermöglichen, das Protonenquantum nicht-benachbarter Scheiben zu messen, das Veränderungsprofil des Protonenquantums pro Scheibe zu zeichnen bzw. zu erstellen und durch Integration des Profils das Gewicht des Produkts, das die Vorrichtung passiert hat, zu berechnen, bis zum Erreichen des gewünschten Produktgewichts.

13. Vorrichtung nach einem der Ansprüche 7 bis 12, **dadurch gekennzeichnet, dass** es außerdem Einrichtungen (18) zur Entnahme des Teils des Produkts umfasst, der dem gewünschten Gewicht entspricht.
